# EUROPEAN PATENT APPLICATION

(11) **EP 3 139 413 A1**
(43) Date of publication of application: **08.03.2017**
(21) Application number: 15785559.4
(22) Date of filing: 09.04.2015
(51) Int. Cl.: H01L 31/0216, H01L 31/0236, H01L 31/042

(54) **PATTERNED SOLAR PANEL STRUCTURE**

(30) Priority: 28.04.2014 CN 201410175600
(71) Applicant: Chen, Tsai-Hui, Nantou City, Nantou County 54068 (CN); Li, Tsui-Huang, Taichung City 41173 (CN)
(72) Inventor: Chen, Tsai-Hui, Nantou City, Nantou County 54068 (CN); Li, Tsui-Huang, Taichung City 41173 (CN)
(74) Representative: Schwerbrock, Florian
(86) International application number: PCT/CN2015/076152
(87) International publication number: WO 2015/165326

(57) **Abstract**

A solar panel with a pattern includes a substrate and an electricity generating layer. A patterned light-transmittable layer is coated on a face of the electricity generating layer. The patterned light-transmittable layer has a transmittance that permits light rays transmitting the patterned light-transmittable layer to form incident rays incident to the substrate and reflective rays reflected by the substrate. The incident rays and reflective rays are sufficient to generate electricity in the electricity generating layer.

## Description

### BACKGROUND OF THE INVENTION

The present invention relates to a solar panel with a pattern and, more particularly, to a solar panel including a face coated with a light-transmittable layer having a pattern to provide an aesthetic appearance while generating electricity.

Recently, solar panels have become one of the widely used mature techniques in green energy for the purposes of developing environmentally friendly energy. Conventional solar panels must be installed in locations with sufficient sunshine to achieve the preset electricity generating effect. In cities where land is valuable, solar panels are often mounted in limited spaces that few people use, such as the rooftops of houses or buildings. However, solar panels require a large space if supply of a large amount of electricity is needed. It is, thus, a main issue in obtaining a sufficient space for installing solar panels while providing the motive of installing solar panels.

Current users are only willing to mount the solar panels on rooftops to which few people access, because the solar panels have a black surface that is deemed not aesthetic to the appearance of the whole building. Thus, there is not much space on the outer surface of the building available for the solar panels. People would rather choose to mount advertisements or decorative boards (which are aesthetic but without energy benefit) on the outer wall faces or glasses of the building. If solar panels can be mounted on a portion of the outer wall faces or glasses of the building, the solar energy generation can significantly be increased.

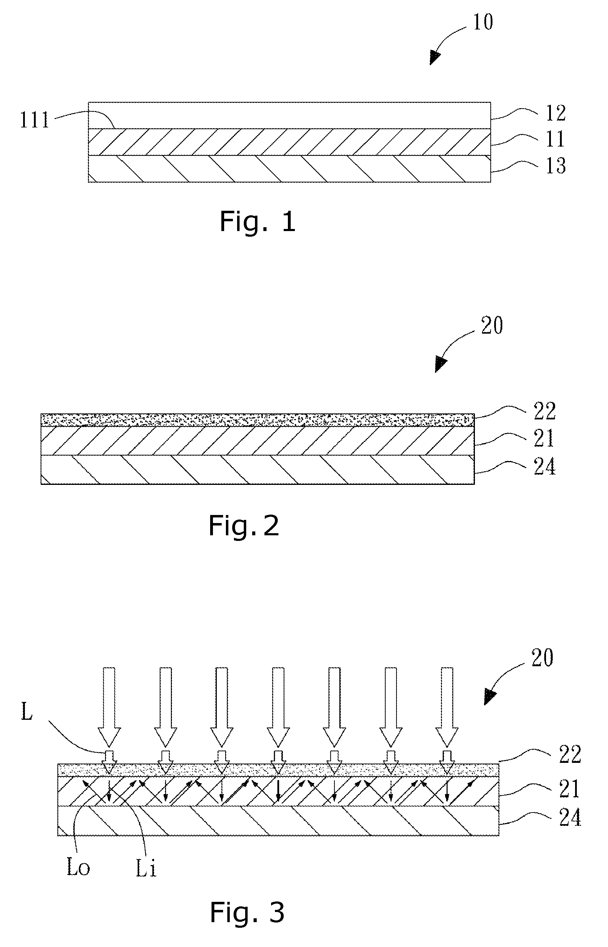

FIG. 1 shows a conventional solar panel 10 including a reflective substrate 13 and an electricity generating layer 11 on the reflective substrate 13. A light-transmittable protective layer 12 is disposed on a surface 111 of the electricity layer 11 to avoid damage to the surface 111. The protective layer 12 is generally made of a light-transmittable material, such as reinforced glass. Since the electricity generating layer 11 of the solar panel 10 is a black series color, the overall appearance of the solar panel 10 is a black series color, which often does not match the appearance of the building. This is why buildings seldom use solar panels 10.

Furthermore, conventional solar panels include dye-sensitized solar cells which are colorful and transmittable to light. However, there are only three colors (blue, red, and yellow) available. Although a large-area color block of different colors can be generated, delicate patterns cannot be configured. As a result, delicate change in the pattern for the appearance is limited.

### BRIEF SUMMARY OF THE INVENTION

A solar panel with a pattern according to the present invention includes a substrate and an electricity generating layer. A patterned light-transmittable layer is coated on a face of the electricity generating layer. The patterned light-transmittable layer has a transmittance that permits light rays transmitting the patterned light-transmittable layer to form incident rays incident to the substrate and reflective rays reflected by the substrate. The incident rays and reflective rays are sufficient to generate electricity in the electricity generating layer.

The patterned light-transmittable layer can include a pattern formed by dying, coating, or bonding.

The patterned light-transmittable layer can be a thin film or made of a soft, light-transmittable material.

The patterned light-transmittable layer can be coated on an outer face of the electricity generating layer to fix and protect the electricity generating layer.

The solar panel can further include a protective layer disposed on an outer face of the patterned light-transmittable layer.

The present invention will become clearer in light of the following detailed description of illustrative embodiments of this invention described in connection with the drawings.

### DESCRIPTION OF THE DRAWINGS

FIG. 1 is a cross sectional view of a conventional solar panel.
FIG. 2 is a cross sectional view of a solar panel of an embodiment according to the present invention.
FIG. 3 is a cross sectional view of the solar panel of FIG. 2, illustrating the path of incident light rays.
FIG. 4 is a cross sectional view of a solar panel of another embodiment according to the present invention.

### DETAILED DESCRIPTION OF THE INVENTION

With reference to FIGS. 2 and 3, a solar panel 20 with a pattern according to the present invention includes a substrate 24 and an electricity generating layer 21 disposed on the substrate 24. The electricity generating layer 21 can be of any structure capable of generating electricity when any light rays enter the electricity generating layer 21. The main feature of the present invention is that a patterned light-transmittable layer 22 is coated on a face of the electricity generating layer 21. The patterned light-transmittable layer 22 can be a thin film or made of a soft, light-transmittable material and can include a pattern formed by dying, coating, or bonding. The patterned light-transmittable layer 22 has a transmittance that permits light rays L transmitting the patterned light-transmittable layer 22 to form incident rays Li incident to the substrate and reflective rays Lo reflected by the substrate 24, wherein a sum of optical energy of the incident rays Li and the reflective rays Lo is sufficient to generate electricity in the electricity generating layer 21.

In addition to the colorful pattern, the electricity generating layer 22 can be coated on an outer face of the electricity generating layer 21 to fix and protect the electricity generating layer 21. A plurality of electricity generating layers 21 can overlap with each other before coated by the patterned light-transmittable layer 22. Thus, even if a protective layer is not disposed on the outer face of the electricity generating layer 21, it is still a complete product for generating electricity while providing an aesthetic appearance.

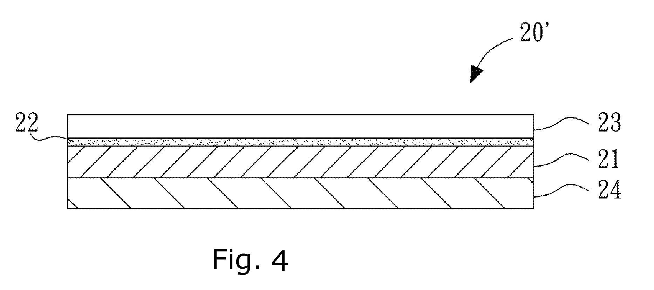

FIG. 4 shows a solar panel 20' of another embodiment according to the present invention. If a better protection is required in an environment in which the solar panel 20 according to the present invention is installed, a protection layer 23 is disposed on an outer face of the patterned light-transmittable layer 22, providing a better visual effect while providing the same protection as conventional solar panels.

Since the color formation of the patterned light-transmittable layer 22 of the solar panel 20 according to the present invention is achieved by dying, spraying or coating, the pigment on the patterned light-transmittable layer 22 must be transmittable to light. By selecting the transmittance of the pigment of the color and by cooperating with the setting of different thickness of the colored layer, a delicate pattern (including figures and/or words) with a certain electricity generating power desired by the designer can be obtained. Alternatively, given a fixed power, an appropriate pattern can be selected while providing the aesthetic demand.

The patterned light-transmittable layer 22 formed by this technique includes the following advantages:
1. The appearance of the solar panel 20 with a pattern according to the present invention can include any desired pattern designed according to the demand of the designer while having a controlled amount of electricity generated by the solar panel 20. The pattern is not comprised of a plurality of color blocks of a dot matrix and, thus, provides an excellent visual effect no matter viewed closely or distantly. In comparison with conventional solar panels using dye-sensitized solar cells providing monotonous color change, the visual effect provided by the solar panel 20 according to the present invention is a great improvement. Such a technical breakthrough in the appearance provides users with a motive to install the solar panel 20 on the outer surface of a building, providing greater environmentally friendly energy-saving effect while maintaining or even improving the appearance of the building.
2. The patterned light-transmittable layer 22 of the solar panel 20 with a pattern according to the present invention not only provides the desired pattern effect but provides protection for the outer face of the electricity generating layer 21. Alternatively, the patterned light-transmittable layer 22 can be disposed between a protection layer 23 and the electricity generating layer 21 to provide better protection.

In view of the foregoing, the solar panel 20 with a pattern according to the present invention can present a pattern on the solar panel 20 and, thus, can be mounted on an outer surface of a building to increase the source of electricity, achieving the goal of green energy. Furthermore, the coating technique of the patterned light-transmittable layer 22 does not interfere with generation of electricity and allows control of the electric current generated while providing a beautifying effect.

Although specific embodiments have been illustrated and described, numerous modifications and variations are still possible without departing from the scope of the invention. The scope of the invention is limited by the accompanying claims.

## Claims

1. A solar panel with a pattern comprising a substrate and an electricity generating layer, with a patterned light-transmittable layer coated on a face of the electricity generating layer, with the patterned light-transmittable layer having a transmittance that permits light rays transmitting the patterned light-transmittable layer to provide incident rays incident to the substrate and reflective rays reflected by the substrate, wherein the incident rays and reflective rays are sufficient to generate electricity in the electricity generating layer.

2. The solar panel with a pattern as claimed in claim 1, wherein the patterned light-transmittable layer includes a pattern formed by dying, coating, or bonding.

3. The solar panel with a pattern as claimed in claim 1, wherein the patterned light-transmittable layer is a thin film or made of a soft, light-transmittable material.

4. The solar panel with a pattern as claimed in claim 1, wherein the patterned light-transmittable layer is coated on an outer face of the electricity generating layer to fix and protect the electricity generating layer.

5. The solar panel with a pattern as claimed in claim 1, further comprising a protective layer disposed on an outer face of the patterned light-transmittable layer.
